(19) **Europäisches Patentamt**
**European Patent Office**
**Office européen des brevets**

(11) **EP 2 680 013 B1**

(12) **EUROPEAN PATENT SPECIFICATION**

(45) Date of publication and mention
of the grant of the patent:
**15.10.2014 Bulletin 2014/42**

(51) Int Cl.:
*G01R 15/18* *(2006.01)*      *G01R 15/20* *(2006.01)*
*G01R 33/04* *(2006.01)*

(21) Application number: **12173999.9**

(22) Date of filing: **28.06.2012**

(54) **Electrical current transducer**

Elektrischer Stromwandler

Transducteur de courant électrique

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**01.01.2014 Bulletin 2014/01**

(73) Proprietor: **LEM Intellectual Property SA**
**1700 Fribourg (CH)**

(72) Inventors:
• **Marcoz, Benjamin**
**74160 Beaumont (FR)**

• **Azzoni, Davide**
**1217 Meyrin (CH)**
• **Schläfli, Dominik**
**1260 Nyon (CH)**
• **Teppan, Wolfram**
**3184 Wünnewil (CH)**

(74) Representative: **reuteler & cie SA**
**Chemin de la Vuarpillière 29**
**1260 Nyon (CH)**

(56) References cited:
**EP-A1- 1 039 307**      **JP-A- 2003 017 347**
**US-A1- 2010 001 715**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to an electrical current transducer for current sensing applications, the transducer comprising a magnetic core and a magnetic field detector.

One method of measuring electrical current is to measure the magnetic field generated by the electrical current to be measured, whereby the current sensor comprises a magnetic circuit made of a highly permeable magnetic material surrounding the conductor to concentrate the magnetic field. A magnetic field detector positioned in an air gap of the magnetic circuit measures the intensity of the magnetic field, which is correlated to the current to be measured. In a closed-loop current transducer, the output of the magnetic field detector is connected in a feedback circuit to a compensation circuit that drives a compensation coil (also known as a secondary coil) to cancel the magnetic field from the primary conductor. The current in the compensation coil forms an image of the current to be measured and can be used to generate the measurement signal output.

A very common form of magnetic core and magnetic field detector arrangement is to provide an air gap transversally extending through a branch of the magnetic core in which the magnetic field detector is positioned. Such a gapped magnetic core provides a high sensitivity in that the magnetic field in the magnetic core is concentrated in the air gap and picked up by the magnetic field detector. One of the drawbacks of this design however is that external magnetic fields, for instance external magnetic fields created by alternating currents in conductors positioned in proximity of the conductor to be measured, influence the current in the secondary coil and thus the measurement signal representing the primary conductor.

Effects of external magnetic fields may be reduced by providing magnetic shielding means, however, such measures are costly, need space and in certain applications are difficult to implement.

*The European patent application* EP 1 039 307 A1 *discloses a magnetic device comprising a magnetic piece having a cavity for receiving a magnetic detector. The magnetic piece of D1 can adopt the shape* of a *yoke interrupted in* one *of its sides.*

*The US patent application* US 2010/001715 A1 *discloses a current sensor that may be folded over a conductor without the need to sever the conductor or thread the conductor through the current sensor. The current sensor of* US 2010/001715 A1 *comprises a cavity for receiving a magnetic detector; however, the implementation as a folded structure, with two halves, avoids having an uninterrupted closed loop around the central passage where the conductor is placed.*

An object of this invention is to provide a closed loop electrical current transducer that is accurate and economical to produce, yet has a high immunity to external magnetic fields, in particular changing or alternating external magnetic fields.

It is an object of this invention to provide an electrical current transducer that is cost-effective to manufacture.

It is advantageous to provide an electrical current transducer that is able to measure a large current amplitude range.

Objects of this invention have been achieved by providing an electrical current transducer according to claim 1.

Disclosed herein is an electric current transducer, including a magnetic core made of a highly magnetically permeable material encircling a central passage configured to receive a primary conductor, and a magnetic field detector. The magnetic core comprising a slot, the magnetic field detector comprising a sensing portion being inserted in said slot. The slot extends completely through the magnetic core, from a radially outer side of the core to a radially inner side of the core, or between axial end faces of the core, the slot being oriented such that at least a portion of the magnetic core forms an uninterrupted closed loop around the central passage.

In a first embodiment, the slot is oriented essentially orthogonally to an axis (A) defined by the central passage.

In a second embodiment, the slot is oriented essentially parallel to the axis (A) defined by the central passage.

In the first embodiment, the slot is arranged between the two opposed axial end faces fully within the core such that the slot is surrounded on all sides by the magnetic core material. In an advantageous variant, the slot is positioned centrally between said end faces, however in other variants the slot may be positioned axially offset from the median position between the opposed axial end faces.

In the second embodiment, the slot extends through the core from one axial end face to the opposed axial end face, the slot being positioned fully within the core between the radially outer side of the core and the radially inner side of the core such that the slot is surrounded on all sides by the magnetic core material.

In an advantageous embodiment, the magnetic field detector sensing portion is inserted in said slot from said radially inner side. Terminals of the magnetic field detector, for connection to signal processing circuitry, may advantageously be arranged adjacent said radially inner side or directed towards the radially inner side such that the outer radial side of the magnetic core is free of obstacles.

In an advantageous embodiment, the slot has an essentially constant width ($W$).

In an advantageous embodiment, the slot has a ratio of average length L to average width $W$ that is greater than 5, the longitudinal direction being essentially parallel to the direction of the magnetic flux density vector.

In an embodiment, the magnetic core has a circular closed loop shape. Other shapes are however possible, such as polygonal, square, rectangular, or other closed irregular shapes surrounding the central passage through which the primary conductor extends.

In an embodiment, the magnetic core is formed of wound thin strip of highly magnetically permeable material.

The slot may advantageously be formed by a machine cutting operation, especially where the magnetic core is formed of a wound strip of material.

In variants, the magnetic core may be formed of a sintered ferrite or of other magnetically permeable materials.

In a variant, the magnetic core may be formed of two parts, the slot being formed at an interface between said two parts.

In an embodiment, the electric current transducer operates as a closed-loop transducer and further comprises a compensation coil wound around the magnetic core.

In an advantageous embodiment, the magnetic field detector may be of the fluxgate type.

Further objects and advantageous features of the invention will be apparent from the claims or description of embodiments of the invention with reference to the annexed figures, in which:

Fig. 1 is a perspective partial cross-sectional schematic view of parts of an electrical current transducer according to an embodiment of the invention, showing a magnetic core, a magnetic field detector, and a compensation winding;

Fig. 2 is a schematic view in perspective of a magnetic core and a magnetic field detector positioned therein of the embodiment shown in Fig. 1;

Fig. 3 is a schematic view in perspective of a magnetic core according to an embodiment of this invention;

Fig. 4 is a schematic side view with partial cross section of a magnetic core according to another embodiment of this invention; and

Fig. 5 is a schematic view in perspective of a magnetic core according to yet another embodiment of this invention.

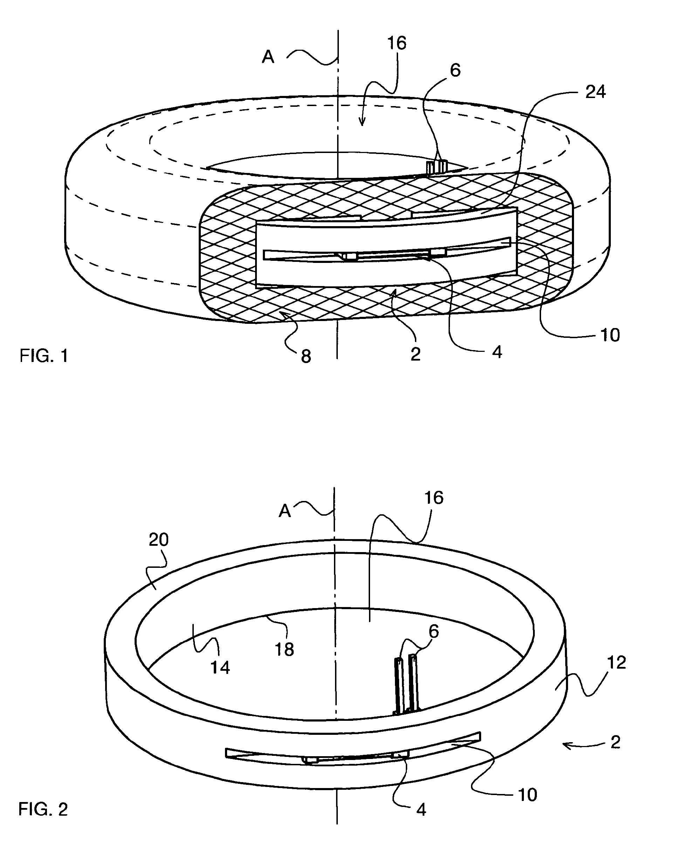

Referring to the Figures, in particular figures 1 and 2, an electrical current transducer 1 comprises a magnetic core 2, 2' and a magnetic field detector 4. The magnetic field detector 4 comprises electrical terminals 6 for connection to a signal processing circuit.

The current transducer comprises a compensation coil 8, also commonly called a "secondary coil", which is connected to the signal processing circuit in a feedback loop controlled by the signal from the magnetic field detector, the functioning principle of such closed-loop configurations being *per se* well-known in the art. The magnetic field detector 4 may comprise a Hall effect sensor in the form of an ASIC, as is *per se* well-known in the art, or may comprise other magnetic field detectors such as fluxgate detectors or giant magneto-resistive (GMR) based magnetic field sensors.

In a variant, the current transducer may comprise an open-loop configuration in which the signal of the magnetic field detector is used to generate the measurement signal, in which case it is not necessary to provide a compensation coil.

The magnetic core 2, 2' comprises a closed configuration, in other words without an air gap cutting completely across the magnetic core loop, that allows at least a portion of the magnetic flux flowing in the core to circulate in the magnetic core without passing through an air gap. This fully closed magnetic core loop configuration provides a very high immunity to external magnetic fields, in particular varying or alternating fields. This high immunity is the consequence of the cancelling effect of the external fields that distribute symmetrically around the magnetic core.

In the embodiments illustrated schematically in figures 1 to 4, the magnetic core 2 comprises a slot 10 extending fully through the magnetic core from a radially outer side 12 to a radially inner side 14, where the radially inner side defines the inner contour of the magnetic core surrounding a central passage 16 through which the primary conductor, in which the current to be measured flows, is inserted. The slot 10 comprises opposed first and second major faces 10a, 10b and opposed minor faces 10c, 10d positioned between opposed axial sides 18, 20 of the magnetic core. The major faces 10a, 10b and minor faces 10c, 10d of the slot form a closed perimeter around the slot. The slot 10 is oriented orthogonally or essentially orthogonally to an axis A extending through the central passage 16, the slot being configured such that it does not cut transversely through the magnetic core, thus ensuring that the magnetic core has a fully closed configuration. The slot 10 may have an essentially constant width and be positioned essentially centrally between opposed axial sides 18, 20, of the magnetic core. The width $W$ of the slot, defined by the distance between the major faces 10a, 10b, is configured to be sufficiently wide to enable insertion of a sensing portion of the magnetic field detector therein, the dimension of the width $W$ thus depending on the type of magnetic field detector that is intended to be inserted in the slot. In a preferred embodiment, the slot advantageously has a constant width such that it may be manufactured easily by a machining operation, for example by means of a rotating cutting blade that cuts through the magnetic core from the radially outer side towards the radially inner side.

In the embodiments illustrated schematically in figures 1 to 4, the slot 10 extends fully through from the radially outer side 12 to the radially inner side 14, which advantageously enables the magnetic field detector to be mounted against the radially inner side of the magnetic core with the sensing portion thereof inserted in the slot 10, leaving the radially outer side 12 on the magnetic core free. The latter configuration advantageously facilitates handling, machining, and assembly operations on the magnetic core, for instance for the winding operation of the compensation coil 8 around the magnetic core. Guiding, holding or positioning tools can engage the radially outer side 12 of the magnetic core without hindrance from the magnetic field sensor positioned against the radially inner side 14.

The magnetic core may advantageously be formed of a wound thin strip or band of highly permeable magnetic material forming a wound toroidal core. Wound toroidal magnetic cores, which are *per se* well known in the art, are cost effective to manufacture and offer a good performance with respect to eddy currents. In an embodiment of the present invention, the slot may advantageously be formed by machining the wound toroidal core the after the winding operation.

The slot in the embodiments illustrated in figures 1 to 3 may advantageously be machined by a cutting blade, for instance a circular cutting blade that has a trajectory in an essentially tangential direction T, or in an essentially orthogonal direction P, or in a curved direction C, whereby the cutting depth is such that the cutting tool completely cuts through the core to form a slot 10 accessible from the radially inner side 14 of the magnetic core.

Within the scope of this invention, the magnetic core can also be formed from other materials or in other manners, for instance out of a ferrite material that is sintered and directly formed with the slot therein. In variants, the slot may have an width $W$ that is non-constant (not shown) and have various shapes. In a variant, the opening from the radially outer side to the radially inner side could also be formed by means of a milling tool instead of a blade cutter. The opening may in a variant comprise a circular or oval shape.

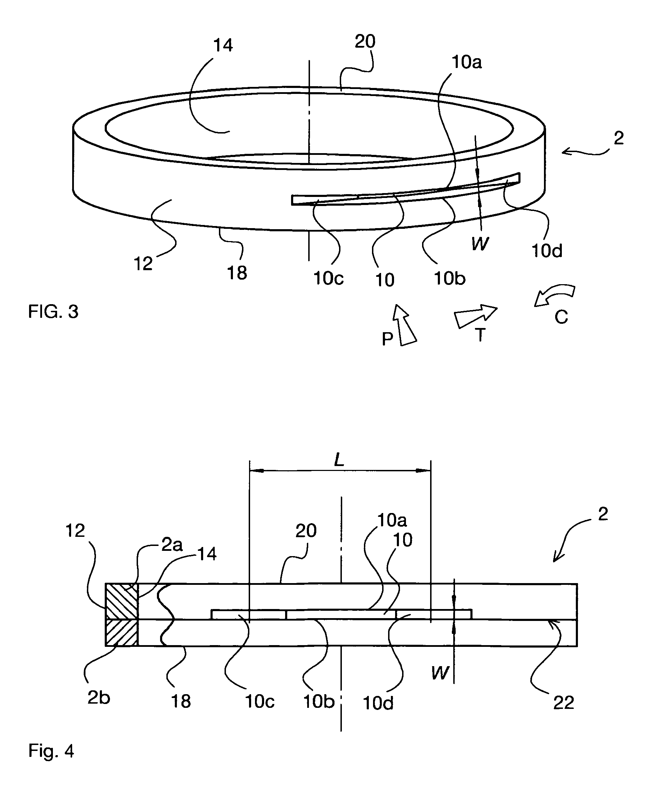

In a variant of the invention, schematically illustrated in figure 4, the magnetic core may be made of two annular core portions 2a, 2b that are assembled together along an interface surface 22 transversely oriented with respect to the axial direction A, to form a core. The slot 10 may be machined or otherwise formed on the interface surfaces prior to assembly of the core portions.

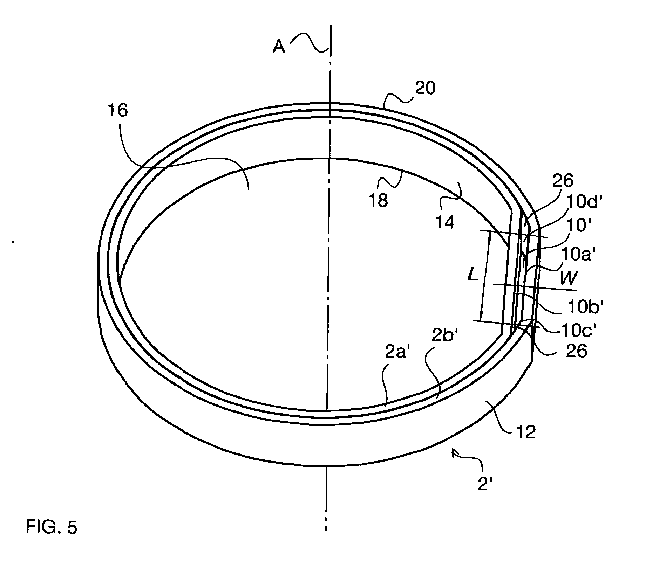

Referring to figure 5, in another embodiment the slot 10' of the magnetic core 2 for receiving the magnetic field detector therein extends fully through the magnetic core from one axial side 18 through to the opposed axial side 20 of the magnetic core. The slot 10' in this embodiment is thus oriented parallel or essentially parallel to the axis A extending through the central passage 16, the slot being configured such that it does not cut transversely through the magnetic core, thus ensuring that the magnetic core has a fully closed configuration. The slot 10' comprises opposed first and second major faces 10a', 10b' and opposed minor faces 10c', 10d' positioned between opposed axial sides 18, 20 of the magnetic core. The major faces 10a', 10b' and minor faces 10c', 10d' of the slot form a closed perimeter around the slot. The slot 10' may be positioned essentially centrally between the radially inner and outer surfaces 12, 14 of the magnetic core. The width $W$ of the slot, i.e. the distance between the major surfaces 10a', 10b', is configured to be sufficiently wide to enable insertion of a sensing portion of the magnetic field detector therein, the magnitude of the width $W$ thus depending on the type of magnetic field detector that is intended to be inserted in the slot 10'.

The configuration of the slot 10' advantageously enables the magnetic field detector to be mounted with connection terminals directed towards the radially inner side of the magnetic core with the sensing portion thereof inserted in the slot 10', leaving the radially outer side 12 on the magnetic core free. The latter configuration advantageously facilitates handling, machining, and assembly operations on the magnetic core, for instance for the winding operation of the compensation coil 8 around the magnetic core. Guiding, holding or positioning tools can engage the radially outer side 12 of the magnetic core without hindrance from the magnetic field sensor positioned against the radially inner side 14.

In this embodiment, the magnetic core 2' may advantageously be formed of a wound thin strip or band of highly permeable magnetic material forming a wound toroidal core, whereby during the winding operation an insert or other spacer device creates a gap between two winding layers during the winding operation to form the slot 10'. The spacer device may be part of the winding machine, or be in the form of an insert (e.g. a plastic spacer insert) that is incorporated in the magnetic core.

The magnetic core 2' can also be formed from other materials or in other manners, for instance out of a ferrite material that is sintered and directly formed with the slot therein, and the slot 10' could also be formed by material removal machining, for instance with a milling tool.

In a variant of the embodiment schematically illustrated in figure 5, the magnetic core 2' may be made of two coaxially arranged annular core portions 2a', 2b' that are assembled together along an interface surface 22' oriented essentially parallel to the axial direction A, to form a core with the slot 10' formed between the two core portions 2a', 2b'.

The current transducer 1 may further comprise an insulating layer (not shown) in an interface 24 (see figure 1) between the magnetic core 2 and the compensation coil 8, as well as a housing (not shown) mounted around the assembly formed by the secondary coil, magnetic core and magnetic field detector.

The slot 2, 2' preferably has a ratio of average distance (length) $L$ between minor faces 10c, 10d 10c', 10d' to average distance (width) $W$ between major faces 10a, 10b, 10a', 10b' that is greater than 5:

$$L / W > 5$$

Preferably, the orientation of the slot, defined by the orientation of the major faces 10a, 10b, 10a', 10b', is essentially parallel to the direction of the magnetic flux density vector, but within the scope of the invention it is possible for the orientation of the slot to be inclined at other angles, for instance at an angle of 45° with respect to the main axis A.

**Claims**

1. An electric current transducer (1), including a magnetic core (2, 2') made of a highly magnetically permeable material surrounding a central passage (16) configured to receive a primary conductor, and a magnetic field detector (4), the magnetic core (2, 2') comprising a slot (10, 10'), the magnetic field detector comprising a sensing portion being inserted in said slot (10, 10'), wherein the slot (10) is formed by opposed first and second major faces (10a, 10b; 10a', 10b') and minor faces (10c, 10d; 10c', 10d') and is positioned within the magnetic core, the slot extending completely through the magnetic core, from a radially outer side (12) to a radially inner side (14) of the core or from a first axial side (18) to an opposed second axial side (20) of the core, the electric current transducer **characterised by** the slot being oriented such that at least a portion of the magnetic core (2) forms an uninterrupted closed loop around the central passage.

2. An electric current transducer according to claim 1, wherein the slot (10) extends through the core (2) from the radially outer side (12) to the radially inner side (14) and is positioned between the two opposed axial sides (18, 20) of the core.

3. An electric current transducer according to claim 2, wherein the central passage defines an axis (A) which extends through said central passage, the first and second major faces (10a, 10b) of the slot (2) being oriented essentially orthogonally to said axis (A).

4. An electric current transducer according to claim 2 or 3, wherein the slot is arranged centrally between said axial sides.

5. An electric current transducer according to claim 1, wherein the slot (10') extends through the core (2') from the first axial side of the core to the opposed second axial side of the core and is positioned between the radially outer side (12) and the radially inner side (14).

6. An electric current transducer according to claim 5, wherein the central passage defines an axis (A) which extends through said central passage, the first and second major faces (10a', 10b') of the slot (2') being oriented essentially parallel to said axis (A).

7. An electric current transducer according to any of the preceding claims, wherein the major faces (10a, 10b; 10a', 10b') and minor faces (10c, 10d; 10c', 10d') of the slot form a closed perimeter.

8. An electric current transducer according to any of the preceding claims, wherein the magnetic field detector sensing portion is inserted in said slot from said radially inner side, the magnetic field detector comprising connection terminals (6) arranged adjacent said radially inner side.

9. An electric current transducer according to any of the preceding claims, wherein the slot has a constant width (*W*).

10. An electric current transducer according to any of the preceding claims, wherein the magnetic core has a circular closed loop shape.

11. An electric current transducer according to any of the preceding claims, wherein the magnetic core is formed of wound thin strip of highly magnetically permeable material.

12. An electric current transducer according to any of the preceding claims, wherein the slot is formed by a machine cutting operation.

13. An electric current transducer according to any of claims 1 to 10, wherein the magnetic core is formed of a ferrite.

14. An electric current transducer according to any of the preceding claims, wherein the magnetic core is formed of two parts (2a, 2b; 2a', 2b') and the slot (2, 2') is formed at an interface (22, 22') between said two parts.

15. An electric current transducer according to any of the preceding claims, wherein the slot (2, 2') has a ratio *L* / *W* of average distance *L* between minor faces (10c, 10d; 10c', 10d') to average distance *W* between major faces (10a, 10b; 10a', 10b') greater than 5.

16. An electric current transducer according to any of the preceding claims, further comprising a compensation coil (8) wound around the magnetic core (2).

17. An electric current transducer according to any of the preceding claims, wherein the magnetic field detector is of the fluxgate type.

**Patentansprüche**

1. Elektrischer Stromwandler (1), der einen Magnetkern (2, 2'), der aus einem Material mit hoher magnetischer Permeabilität hergestellt ist, der einen zentralen Durchgang (16) umgibt, der ausgestaltet ist, um einen Hauptleiter aufzunehmen, und einen Magnetfelddetektor (4) umfasst, wobei der Magnetkern (2, 2') einen Schlitz (10, 10') umfasst, wobei der Magnetfelddetektor einen Abtastabschnitt umfasst, der in den Schlitz (10, 10') eingefügt ist, wobei der Schlitz (10) durch entgegengesetzte erste und zweite große Flächen (10a, 10b; 10a', 10b') und kleine Flächen (10c, 10d; 10c', 10d') gebildet ist und innerhalb des Magnetkerns positioniert ist, wobei der Schlitz sich vollständig durch den Magnetkern von einer radial äußeren Seite (12) zu einer radial inneren Seite (14) des Kerns oder von einer ersten axialen Seite (18) zu einer entgegengesetzten zweiten axialen Seite (20) des Kerns erstreckt, wobei der elektrische Stromwandler **dadurch gekennzeichnet ist, dass** der Schlitz derart ausgerichtet ist, dass zumindest ein Abschnitt des Magnetkerns (2) eine ununterbrochene geschlossene Schleife um den mittleren Durchgang herum bildet.

2. Elektrischer Stromwandler nach Anspruch 1, wobei der Schlitz (10) sich durch den Kern (2) von der radial äußeren Seite (12) zur radial inneren Seite (14) erstreckt und zwischen den zwei entgegengesetzten axialen Seiten (18, 20) des Kerns positioniert ist.

3. Elektrischer Stromwandler nach Anspruch 2, wobei der mittlere Durchgang eine Achse (A) definiert, die sich durch den mittleren Durchgang erstreckt, wobei die erste und die zweite große Fläche (10a, 10b) des Schlitzes (2) im Wesentlichen orthogonal zu der Achse (A) ausgerichtet sind.

4. Elektrischer Stromwandler nach Anspruch 2 oder 3, wobei der Schlitz zentral zwischen den axialen Seiten angeordnet ist.

5. Elektrischer Stromwandler nach Anspruch 1, wobei der Schlitz (10') sich durch den Kern (2') von der ersten axialen Seite des Kerns zur entgegengesetzten zweiten axialen Seite des Kerns erstreckt und zwischen der radial äußeren Seite (12) und der radial inneren Seite (14) positioniert ist.

6. Elektrischer Stromwandler nach Anspruch 5, wobei der mittlere Durchgang eine Achse (A) definiert, die sich durch den mittleren Durchgang erstreckt, wobei die erste und die zweite große Fläche (10a', 10b') des Schlitzes (2') im Wesentlichen parallel zu der Achse (A) ausgerichtet sind.

7. Elektrischer Stromwandler nach einem der vorhergehenden Ansprüche, wobei die großen Flächen (10a, 10b; 10a', 10b') und kleinen Flächen (10c, 10d; 10c', 10d') des Schlitzes einen geschlossenen Umkreis bilden.

8. Elektrischer Stromwandler nach einem der vorhergehenden Ansprüche, wobei der Magnetfelddetektor-Abtastabschnitt von der radial inneren Seite in den Schlitz eingefügt ist, wobei der Magnetfelddetektor Verbindungsanschlüsse (6) umfasst, die der radial inneren Seite benachbart angeordnet sind.

9. Elektrischer Stromwandler nach einem der vorhergehenden Ansprüche, wobei der Schlitz eine konstante Breite (W) aufweist.

10. Elektrischer Stromwandler nach einem der vorhergehenden Ansprüche, wobei der Magnetkern die Form einer kreisförmigen geschlossenen Schleife aufweist.

11. Elektrischer Stromwandler nach einem der vorhergehenden Ansprüche, wobei der Magnetkern aus einem gewickelten dünnen Streifen aus Material mit hoher magnetischer Permeabilität gebildet ist.

12. Elektrischer Stromwandler nach einem der vorhergehenden Ansprüche, wobei der Schlitz durch einen Maschinenschneide-Arbeitsvorgang gebildet ist.

13. Elektrischer Stromwandler nach einem der Ansprüche 1 bis 10, wobei der Magnetkern aus einem Ferrit gebildet ist.

14. Elektrischer Stromwandler nach einem der vorhergehenden Ansprüche, wobei der Magnetkern aus zwei Teilen (2a, 2b; 2a', 2b') gebildet ist und der Schlitz (2, 2') an einer Grenzfläche (22, 22') zwischen den zwei Teilen gebildet ist.

15. Elektrischer Stromwandler nach einem der vorhergehenden Ansprüche, wobei der Schlitz (2, 2') ein Verhältnis L / W des durchschnittlichen Abstands L zwischen kleinen Flächen (10c, 10d; 10c', 10d') zu einem durchschnittlichen Abstand W zwischen großen Flächen (10a, 10b; 10a', 10b') aufweist, das größer als 5 ist.

16. Elektrischer Stromwandler nach einem der vorhergehenden Ansprüche, der ferner eine Kompensationsspule (8) umfasst, die um den Magnetkern (2) herum gewickelt ist.

17. Elektrischer Stromwandler nach einem der vorhergehenden Ansprüche, wobei der Magnetfelddetektor vom Typ Fluxgate ist.

**Revendications**

1. Transducteur de courant électrique (1) comprenant un noyau magnétique (2, 2') réalisé avec un matériau magnétique hautement perméable entourant un passage central (16) configuré pour recevoir un conducteur principal, et un détecteur de champ magnétique (4), le noyau magnétique (2, 2') comprenant une fente (10, 10'), le détecteur de champ magnétique comprenant une partie de détection qui est insérée dans ladite fente (10, 10'), dans lequel la fente (10) est formée par des premières et secondes faces majeures (10a, 10b ; 10a', 10b') et faces mineures (10c, 10d ; 10c', 10d') opposées et est positionnée à l'intérieur du noyau magnétique, la fente s'étendant complètement à travers un noyau magnétique, à partir d'un côté radialement externe (12) jusqu'à un côté radialement interne (14) du noyau ou à partir d'un premier côté axial (18) jusqu'à un second côté axial (20) opposé du noyau, le transducteur de courant électrique étant **caractérisé par** la fente qui est orientée de sorte qu'au moins une partie du noyau magnétique (2) forme une boucle fermée non interrompue autour du passage central.

2. Transducteur de courant électrique selon la revendication 1, dans lequel la fente (10) s'étend à travers le noyau (2), à partir du côté radialement externe (12) jusqu'au côté radialement interne (14) et est positionnée entre les deux côtés axiaux (18, 20) opposés du noyau.

3. Transducteur de courant électrique selon la revendication 2, dans lequel le passage central définit un axe (A) qui s'étend à travers ledit passage central, les première et seconde faces majeures (10a, 10b) de la fente (2) étant orientées de manière essentiellement orthogonale audit axe (A).

4. Transducteur de courant électrique selon la revendication 2 ou 3, dans lequel la fente est agencée au centre entre lesdits côtés axiaux.

5. Transducteur de courant électrique selon la revendication 1, dans lequel la fente (10') s'étend à travers le noyau (2') à partir du premier côté axial du noyau jusqu'au second côté axial opposé du noyau et est positionnée entre le côté radialement externe (12) et le côté radialement interne (14).

6. Transducteur de courant électrique selon la revendication 5, dans lequel le passage central définit un axe (A) qui s'étend à travers ledit passage central, les première et seconde faces majeures (10a', 10b') de la fente (2') étant orientées de manière essentiellement parallèle audit axe (A).

7. Transducteur de courant électrique selon l'une quelconque des revendications précédentes, dans lequel les faces majeures (10a, 10b ; 10a', 10b') et les faces mineures (10c, 10d ; 10c', 10d') de la fente forment un périmètre clos.

8. Transducteur de courant électrique selon l'une quelconque des revendications précédentes, dans lequel la partie de détection de détecteur de champ magnétique est insérée dans ladite fente à partir dudit côté radialement interne, le détecteur de champ magnétique comprenant des bornes de raccordement (6) agencées de manière adjacente audit côté radialement interne.

9. Transducteur de courant électrique selon l'une quelconque des revendications précédentes, dans lequel la fente a une largeur constante (W).

10. Transducteur de courant électrique selon l'une quelconque des revendications précédentes, dans lequel le noyau magnétique a une forme de boucle fermée circulaire.

11. Transducteur de courant électrique selon l'une quelconque des revendications précédentes, dans lequel le noyau magnétique est formé d'une fine bande enroulée de matériau magnétique hautement perméable.

12. Transducteur de courant électrique selon l'une quelconque des revendications précédentes, dans lequel la fente est formée par une opération de découpe à la machine.

13. Transducteur de courant électrique selon l'une quelconque des revendications 1 à 10, dans lequel le noyau magnétique est formé à partir d'une ferrite.

14. Transducteur de courant électrique selon l'une quelconque des revendications précédentes, dans lequel le noyau magnétique est formé de deux parties (2a, 2b ; 2a', 2b') et la fente (2, 2') est formée au niveau d'une interface (22, 22') entre lesdites deux parties.

15. Transducteur de courant électrique selon l'une quelconque des revendications précédentes, dans lequel la fente (2, 2') a un rapport L / W de distance moyenne L entre les faces mineures (10c, 10d ; 10c', 10d') sur la distance moyenne W entre les faces majeures (10a, 10b ; 10a', 10b') supérieur à 5.

16. Transducteur de courant électrique selon l'une quelconque des revendications précédentes, comprenant en outre une bobine de compensation (8) enroulée autour du noyau magnétique (2).

17. Transducteur de courant électrique selon l'une quelconque des revendications précédentes, dans lequel le détecteur de champ magnétique est du type fluxgate.

FIG. 1

FIG. 2

FIG. 3

Fig. 4

FIG. 5

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1039307 A1
- US 2010001715 A1